# EUROPEAN PATENT SPECIFICATION

(11) **EP 1 520 454 B1**
(45) Date of publication and mention of the grant of the patent: **25.01.2012**
(21) Application number: 03762158.8
(22) Date of filing: 27.06.2003
(51) Int. Cl.: H05K 3/44, H05K 3/46, H05K 3/00

(54) **SINGLE OR MULTI-LAYER PRINTED CIRCUIT BOARD WITH EXTENDED BREAKAWAY TABS AND METHOD OF MANUFACTURE THEREOF**
EIN- ODER MEHRSCHICHTIGE LEITERPLATTE MIT VORSTEHENDEN SOLLBRUCH-LASCHEN UND VERFAHREN ZU DEREN HERSTELLUNG
CARTE DE CIRCUIT IMPRIME SIMPLE OU MULTICOUCHES A LANGUETTES DE RUPTURE ALLONGEES ET SON PROCÉDÉ DE FABRICATION

(30) Priority: 27.06.2002 US 184387; 26.08.2002 US 227768
(43) Date of publication of application: 06.04.2005
(73) Proprietor: PPG Industries Ohio, Inc., Cleveland, OH 44111 (US)
(72) Inventor: WANG, Alan E., Gibsonia, PA 15044 (US); OLSON, Kevin C., Wexford, PA 15090 (US); DI STEFANO, Thomas H., Monte Sereno, CA 95030 (US)
(74) Representative: Polypatent
(86) International application number: PCT/US2003/020361
(87) International publication number: WO 2004/004432

(56) References cited:
- EP-A- 0 264 105
- EP-A- 0 365 755
- US-A- 3 934 334
- US-A- 4 250 616
- US-A- 5 614 698
- "DECOUPLING CAPACITOR ATTACHMENT METHOD" RESEARCH DISCLOSURE, KENNETH MASON PUBLICATIONS, HAMPSHIRE, GB, no. 319, November 1990 (1990-11), page 880 XP000160168 ISSN: 0374-4353
- PATENT ABSTRACTS OF JAPAN vol. 1997, no. 03, 31 March 1997 (1997-03-31) -& JP 08 288660 A (NIPPON AVIONICS CO LTD), 1 November 1996 (1996-11-01)
- PATENT ABSTRACTS OF JAPAN vol. 016, no. 285 (E-1222), 24 June 1992 (1992-06-24) -& JP 04 071285 A (NIPPON AVIONICS CO LTD), 5 March 1992 (1992-03-05)
- PATENT ABSTRACTS OF JAPAN vol. 014, no. 557 (E-1011), 11 December 1990 (1990-12-11) -& JP 02 241089 A (FUJITSU LTD), 25 September 1990 (1990-09-25)

## Description

### BACKGROUND OF THE INVENTION

Presently, printed circuit boards are fabricated as part of a larger panel. Each printed circuit board can be configured in any shape, although most printed circuit boards in common use are made in rectangular shapes of standard sizes. When fabrication of a printed circuit board is complete, it is cut and separated from the larger panel, mostly by way of a machine cutting or routing process in which a channel is cut around the printed circuit board. In certain designs, the channel around the printed circuit board does not completely encircle the perimeter of the printed circuit board. Rather, tabs are left at several places around the perimeter of the printed circuit board to attach it to the larger panel until the board is singulated from the larger panel by breaking the tabs. Typically, metal planes in the printed circuit board do not extend to its edge where they would be cut by the routing process. In this way, no conductive metal is left exposed on the edges of the printed circuit board.

The existing methods of cutting printed circuit boards from larger panels are unsatisfactory for high density boards because the limited dimensional stability of the printed circuit boards does not allow registration of one high density pattern to the next on the larger panel. Cut lines made around the periphery of the printed circuit board further weaken the panel material, exasperating misregistration of one pattern to the next.

Electronic systems assembled onto conventional printed circuit boards rely upon thermal conduction from integrated circuits dissipating heat to the printed circuit board to remove some of the heat from the integrated circuits. For intermediate ranges of heat, up to about 2 watts per chip, conduction to the printed circuit board is sufficient to cool the integrated circuits without the need for bulky and expensive heat sinks. In high performance systems, however, as the density of the system and the percentage of the substrate covered by the integrated circuits increases, the thermal path to the printed circuit board is less efficient. At a point when the density of the system increases sufficiently, the printed circuit board is not effective as a heat sink for the integrated circuits. However, the need for effective thermal conduction from the integrated circuits to the substrate and therefrom to the ambient becomes more important as system density increases. Because of the evolution toward higher system density and larger integrated circuit coverage, means are needed for cooling the substrate in order to maintain the integrated circuits on the substrate at a safe operating temperature.

In addition to thermal conduction, high performance systems increasingly require low impedance power and ground voltage supplies to run the integrated circuits at high clock speeds. Typically, the AC impedances of power and ground supplies are lowered by the use of low impedance bypass capacitors connected to the power and ground planes. On conventional printed circuit boards, capacitors are connected to power and ground planes through vias which extend through some thickness of the board, increasing the impedance of this contact and degrading performance of the system. As switching speeds increase, the problem of making low impedance connections between bypass capacitors and the power and ground planes becomes more important.
In EP 0 264 105 A2 a method of producing multilayer printed-wiring boards containing a metal core is disclosed. Copper cores are provided with slits for separating a product portion from the peripheral portion of the copper cores, wherein the slits are filled with an insulating resin during manufacturing of the copper cores. A set of copper cores are then stacked with prepegs and should provide an insulation between the copper cores. In one embodiment the multilayer body comprises outer layer plates carrying a conductive plating with a desired circuit pattern, which top and bottom layers do not comprise slits filled with insulating resin. In another embodiment, the slits of different copper cores do not overlap each other when forming the multilayer body. In a further embodiment minor slits or through-holes are formed through the whole or part of the multilayer body filled with the insulating resin, During manufacturing of the multilayer body the product portion is separated from the peripheral portion by cutting along lines passing through the insulating resin so that parts of the insulating resin remain on minor parts of the edges of the multilayer body.
US 4,250,616 discloses a method of forming an electrical backplane in the form of a multilayer printed circuit board wherein each of the conductive layers comprises certain slots or holes which are filled solid with an insulative material. The slots comprising the insulative material do not overlap each other when stacked together, but the slots of one plane overlap and extent beyond the tie bars of the other plane. During manufacturing of the backplane the peripheral rim areas are machined off medially along the aligned slots. According to the teaching of US 4,250,616 this arrangement provides that no metal edges of one plate are adjacent to metal edges of the other plate, thus eliminating arcing across the plates because of machining burrs or the like.
JP 08 288660 A discloses a multilayered metal core printed wiring board manufactured from a lamination board with a product region and a waste region, wherein slits are formed in each metal core providing linkage parts between the product portion and the waste portion. The slits and linkage parts are so formed and arranged that the linkage part of one metal core do not overlap the linkage part of another metal core as to prevent a plurality of the metal cores from being exposed to the cutting hole for cutting the linkage parts.
From JP 04 071285 A a metal core printed wiring board and profiling method is known wherein the metal cores of the board are provided with a product region and a waste region on the periphery of the product region separated by a slit between them. The slit leaves a number of coupling parts which link both regions to each other. When the metal cores are stacked together within insulating layers to form the printed wiring board the external shape of the board is cut along the slit thereby separating the product region from the waste region. The slits provide that the external shape is efficiently cut without using a metal mould to advance productivity of the printed wiring board manufacture.
US 3,934,334 describes an additive process for producing printed wiring boards using a metal blanked sheet metal comprising a lead frame and several metal substrates wherein slits are provided in the sheet metal to separate the metal substrates for each printed wiring board from each other, and additional slits which separate the metal substrates from the lead frame leaving only small connecting portions between the substrate portion and the lead frame portion to ease cutting of the printed circuit boards from another and from the lead main frame for packing and shipping at the end of the manufacturing process.
US 5,614,698 discloses a multilayer circuit board and manufacturing method wherein a conductive layer comprises spaced-part finger sections that extend outwardly from the electrically conductive portion used for the circuitry to an outer rim section, so that when the product section of the board is cut from the waste rim sections during manufacturing of the board a pattern of conductive section is exposed at an edge of the circuit board to provide a bar code type structure carrying information about the printed circuit board. The cleanly exposed end surface of the finger sections may be read by an adapted appropriate bar code reader to receive a variety of identification and technical information of the circuit board particularly used for automatic manufacturing processes using such circuit boards.

It is, therefore, an object of the present invention to overcome the above problems and others by providing a printed circuit board having one or more printed circuit board layers having a conductive plane which extends, to the edge of the printed circuit board but which is substantially, but not completely, covered by an insulating material. The edge of the conductive layer not covered by the insulating material can be on the edge of a tab which is utilized to couple the board to a disposable part of a larger panel that the board is formed from during fabrication. The exposed edge of the conductive layer becomes exposed upon breaking the tab and singulating the printed circuit board from the disposable part of the larger panel. In one embodiment, the tab terminates in a recess in the perimeter of the printed circuit board. In another embodiment, the tab extends outward from the perimeter of the printed circuit board.

The conductive plane can be formed from metal, such as a copper foil, that can serve the dual purpose of conducting heat away from electrical components disposed on one or both surfaces of the printed circuit board or printed circuit board layer and for providing power or ground to the electrical components. The tab which extends outward from the edge of the second embodiment of the printed circuit board can be coupled to a mechanical fixture and/or an electrical fixture to provide a path for the flow of heat from the printed circuit board to externally coupled mechanical fixtures and/or to provide electrical power to the electrically conducting layer of the printed circuit board. Still other objects will become apparent to those of ordinary skill in the art upon reading and understanding the following detailed description.

### SUMMARY OF THE INVENTION

The invention relates to a circuit board according to claim 1.

The conductive sheet can include at least one via therethrough. The insulating layers can be formed from a common dielectric material deposited on the conductive sheet by conformal coating. At least one of the top and bottom layers can have a circuit pattern formed thereon.

The insulating edge layer include at least one opening where a part of the edge of the conductive sheet is exposed in response to separating the circuit board layer from a panel. Moreover, the exposed part of the edge is on a tab attached to the circuit board layer where the tab extends into a recess in the circuit board layer.

The top and bottom insulating layers and the conductive sheet define a panel that includes the circuit board layer coupled to a disposable part of the panel by the tab. The insulating edge layer covers the edges of the tab and the circuit board layer prior to singulation of the circuit board layer from the disposable part of the panel. The tab is responsive to a breaking force applied thereto for breaking whereupon the circuit board layer separates from the disposable part of the panel with at least part of the tab remaining attached to the circuit board layer.

The conductive sheet includes a tab that extends outward from between the top layer and the bottom layer. At least part of the edge of the tab is exposed when the circuit board layer is separated from the disposable part of the panel. The at least part of the edge is outside a perimeter of the circuit board layer. The tab in this embodiment has a top surface and a bottom surface. At least part of one of the top surface and the bottom surface of the tab is exposed, i.e., not covered by insulating material.

A plurality of circuit board layers can be laminated together to form a multi-layer circuit board. The tab of one circuit board layer of the multi-layer circuit board can be offset from the tab of another circuit board layer of the multi-layer circuit board. An electronic component can be connected between the tab of one circuit board layer and the tab of the other circuit board layer. The conductive sheet of one circuit board layer can define the ground plane of the multi-layer circuit board and the conductive sheet of another circuit board layer can define a power plane of the multi-layer circuit board.

The invention is also a method of forming a circuit board according to claim 1 that includes providing a first conductive sheet and selectively removing one or more portions of the first conductive sheet to form a first panel having a first circuit board that is coupled to a disposable part of the first panel by at least one tab that extends from an edge of the first circuit board to an edge of the disposable part of the first panel. An insulating coating is applied to the first circuit board so at least each edge of the first circuit board is covered thereby. The first circuit board is separated from the disposable part in a manner whereupon at least part of the tab remains attached to the first circuit board and this part of the tab includes an exposed edge of the conductive sheet of the first circuit board.

The insulating coating can be applied to the first circuit board in a manner whereupon at least each edge of the at least one tab is covered thereby. The at least part of the tab can terminate one of inside and outside a perimeter of the first circuit board.

The method can also include providing a second conductive sheet and selectively removing one or more portions of the second conductive sheet to form a second panel having a second circuit board that is coupled to a disposable part of the second panel by at least one tab that extends from an edge of the second circuit board to an edge of the disposable part of the second panel. An insulating coating is applied to the second circuit board so that at least each edge of the second circuit board is covered thereby. The first and second circuit boards are then laminated together and the second circuit board is separated from the disposable part of the second panel in a manner whereupon at least part of the tab remains attached to the second circuit board and the at least part of the tab includes an exposed edge of the conductive sheet of the second circuit board.

The at least part of each tab can terminate inside or outside a perimeter of the corresponding circuit board. When the first and second circuit boards are laminated together, the at least one tab of the first circuit board is offset from the at least one tab of the second circuit board. An electrical component can be electrically connected between the at least one tab of the first circuit board and the at least one tab of the second circuit board.

A printed circuit board layer includes an electrically conductive sheet or foil. Sheet can be formed from a copper foil, an iron-nickel alloy, or combinations thereof. Sheet can be a perforate sheet or can be a solid sheet. It is desirable for sheet to have a coefficient of thermal expansion comparable to that of silicon materials from which integrated circuits are typically prepared in order to prevent failure of adhesion joints utilized to adhere the integrated circuit or a packaged integrated circuit to printed circuit board layer. Describing sheet as perforate means that sheet is a mesh sheet having a plurality of through-holes or vias spaced at regular intervals.

An electrically insulative coating is formed around sheet. This coating is formed around sheet by conformal coating. More specifically, coating forms an insulating top layer which covers a top surface of sheet, an insulating bottom layer which covers a bottom surface of sheet and an insulating edge layer which covers an edge of sheet. When sheet is coated with coating, an interior surface of each through-hole or via is also coated with coating. Thus, no portion of sheet is left uncovered by coating.

Printed circuit board layer formed in the above-described manner can have a conductive pattern formed on the outward facing surface of top layer and/or the outward facing surface of bottom layer by conventional processes. Specifically, utilizing one or more photolithographic techniques and one or more metallization techniques, the conductive pattern can be formed on the outward facing surface of top layer and/or the outward facing surface of bottom layer. This conductive pattern can include un-plated through-holes or vias, plated, blind through-holes or vias, and/or plated through-holes or vias. Additional details regarding formation of printed circuit board layer and for forming a conductive pattern, including one or more of the various types of through-holes or vias, on top layer and/or bottom layer can be found in U.S. Patent Application Serial No. 10/184,387, filed June 27, 2002, entitled "Process For Creating Vias For Circuit Assemblies".

The preparation of one or more printed circuit board layers in a panel form and the assembly of plural printed circuit board layers to form a multi-layer printed circuit board assembly will now be described.

In accordance with a first embodiment of the invention, one or more first printed circuit board (PCB) layers are fabricated as part of a panel. Each first PCB layer is surrounded by a disposable part of panel. In accordance with the present invention, each first PCB layer is coupled to disposable part of panel by one or more tabs.

Initially, a first conductive sheet, like conductive sheet, of the size of panel is provided. This sheet can either be a solid sheet or a perforate sheet depending on the application. Next, cut lines or slots are formed in the conductive sheet by pattern etching or a machine cutting or routing process to define the perimeter of each first PCB layer of panel. These slots are interrupted by tabs which hold each first PCB layer to disposable part during processing.

Next, an electrically insulative coating, like coating, is deposited on the conductive sheet forming panel in a manner whereupon the top surface, the bottom surface, and the edges of the electrically conductive sheet associated with each first PCB layer that were exposed during the formation of slots are covered thereby. If the conductive sheet is perforate, the electrically insulative coating also covers the interior surface of each through-hole or via. In addition, the top and bottom surfaces and the edges of each tab defined during the formation of slots are covered by the electrically insulative coating according to claim 1.

Next, photolithographic processing techniques and metallization techniques known in the art and described in the above-identified United States patent application are utilized to define a circuit pattern on one or both of the exposed surfaces of the electrically insulative coating deposited on the portion of the electrically conductive sheet associated with each first PCB layer.

If each first PCB layer is ready for use after circuit pattern is formed thereon, each first PCB layer can be singulated from panel by applying a breaking force to the tabs connecting each first PCB layer to disposable part. However, if desired, one or more additional layers of electrically insulative coating and circuit patterns can be formed over circuit pattern, with the various layers of circuit patterns interconnected in a desired manner utilizing conventional processes. Thereafter, each first PCB layer can be singulated from panel by applying a breaking force to each tab connecting each first PCB layer to disposable part.

Alternatively, each first PCB layer of panel can be laminated to a second PCB layer of a panel. Panel includes one or more second PCB layers connected to a disposable part of panel by tabs defined during formation of slots in the electrically conductive sheet of panel in the same manner described above in connection with the formation of slots in panel.

An electrically insulative coating is deposited on the conductive sheet forming panel in a manner whereupon the top surface, the bottom surface and the edges of electrically conductive sheet associated with each second PCB layer that were exposed during the formation of slots are covered thereby. If the conductive sheet is perforate, the electrically insulative coating also covers the interior surface of each through-hole or via. In addition, the top and bottom surfaces and the edges of each tab defined during the formation of slots can also be covered by the electrically insulative coating. The top and bottom surfaces and the edges of disposable part defined during formation of slots are covered with the electrically insulative coating according to claim 1.

Each second PCB layer has a circuit pattern formed on one or both of the exposed surfaces of the electrically insulative coating deposited on the portion of the electrically conductive sheet associated with each second PCB layer. If desired, each second PCB layer can include one or more additional layers of electrically insulative coating and circuit patterns formed over circuit pattern, with the various layers of circuit patterns interconnected in the desired manner utilizing conventional processes.

Panels can be laminated together in a manner known in the art, with each first PCB layer positioned in registry with a corresponding second PCB layer to form a multi-layer PCB assembly. Appropriate techniques known in the art can be utilized to form one or more electrical connections between each circuit pattern and the corresponding circuit pattern. For simplicity of description, the formation of these one or more electrical connections between circuit pattern and corresponding circuit pattern will not be described herein.

Tabs of panel do not overlay tabs of panel when panels are laminated together. In this manner, the PCB layers forming each multi-layer PCB assembly can be singulated from their disposable parts , respectively, independent of each other. If desired, however, one or more tabs can be in alignment with each other when panels are laminated.

Each tab will now be described with respect to an exemplary tab of panel. However, it is to be appreciated that each tab of panel is similar to each tab of panel and, therefore, the following description of exemplary tab is applicable to each tab.

Exemplary tab extends between first PCB layer and disposable part. To facilitate breaking, exemplary tab includes a narrowing, also known as a Charpy notch, along its length. This narrowing enables exemplary tab to break at a well-defined position whereupon exemplary tab separates into a first part that remains attached to first PCB layer and a second part that remains attached to disposable part.

The ends of slots on opposite sides of exemplary tab define a recess within a perimeter of first PCB layer. For purpose of the present description, perimeter of first PCB layer includes the outer edge of first PCB layer and the imaginary extension of outer edges across each recess The narrowing of each tab is within perimeter of first PCB layer. Hence, when exemplary tab separates into first part and second part, a distal end of each first part terminates within recess.

Since first PCB layer and exemplary tab include an electrically conductive sheet, like sheet, coated with an electrically insulative coating, like coating, breaking exemplary tab exposes a small portion of the edge of electrically conductive sheet, and the surrounding electrically insulative coating. Since only the distal end of first part of exemplary tab includes small portion of electrically conductive sheet exposed, substantially all of the edge of electrically conductive sheet is covered by electrically insulative coating and, more particularly, the insulating edge layer of electrically insulative coating. Accordingly, inadvertent electrical contact with the edge of electrically conductive sheet covered with the insulating edge layer of electrically insulative coating is avoided.

The electrically conductive sheet of first PCB layer and second PCB layer can be utilized to conduct heat away from electrical components disposed on one or both surfaces thereof. In addition, the electrically conductive sheets of PCB layers of each multi-layer PCB assembly can be utilized to provide power and ground to electrical components disposed on the outward facing surfaces of multi-layer PCB assembly. This is accomplished by connecting the power lead of each integrated circuit disposed on multilayer PCB assembly to the conductive sheet of one PCB layer and connecting the ground lead of each integrated circuit to the conductive sheet of the other PCB layer . The conductive sheet of each PCB layer can then be connected to an appropriate one of a power terminal and a ground terminal of an external power supply via the small portion of the edge of the electrically conductive sheet exposed on the first part of one or more tabs by suitable fixture means.

In accordance with a second embodiment of the invention, a first PCB layer is fabricated in the same manner as first PCB layer discussed above. In this second embodiment, however, one or more tabs extend outward from a perimeter of first PCB layer and connect it to a disposable part of a panel that also includes first PCB layer and tab. In a manner similar to PCB layers and tabs, respectively, first PCB can be formed from an electrically conductive sheet having its top and bottom surfaces and edges coated with an electrically insulative coating. However, in this second embodiment, the electrically insulative coating can be omitted from one or more tabs or can be removed from one or more tabs after deposit. One or more of tabs can each include a mounting hole that can be utilized to couple tab to mounting hardware or external electrical circuitry, such as a power supply.

A circuit pattern can be formed on one or both exposed surfaces of first PCB layer utilizing photolithographic processing techniques and metallization techniques known in the art. Once first PCB layer has circuit pattern formed on one or both exposed surfaces thereof, first PCB layer and each tab can be singulated from panel, especially disposable part, and utilized as is. If desired, however, one or more additional layers of electrically insulative coating and circuit patterns can be formed over circuit pattern , with the various layers of circuit patterns interconnected in a desired manner utilizing conventional processes. Thereafter, first PCB layer and each tab can be singulated from panel.

If desired, panel can be laminated to a panel in a manner known in the art with first PCB layer in registry with a second PCB layer of panel to form a multi-layer PCB assembly. Second PCB layer is part of panel that includes tabs and disposable part. One or more tabs can each include a mounting hole that can be utilized to couple tab to appropriate mechanical hardware or electrical circuitry. In a manner similar to PCB layers and tabs, respectively, second PCB layer and tabs can be formed from an electrically conductive sheet coated with an electrically insulative coating. However, in this second embodiment, the electrically insulative coating can be omitted from each tab or can be removed from each tab after deposit.

A circuit pattern can be formed on one or both surfaces of second PCB layer utilizing photolithographic processing techniques and metalization techniques known in the art. Once first PCB layer and second PCB layer are laminated in registry, appropriate techniques known in the art can be utilized to form one or more electrical connections between circuit pattern and the circuit pattern.

Next, a breaking force can be applied to each tab and to singulate first and second PCB layers and, hence, multi-layer PCB assembly, from disposable parts. To facilitate the application of a breaking force to each tab, tabs can be positioned on first and second PCB layers so that they do not overlay each other. All of each tab and all of each tab remains with first and second PCB layers , respectively. To this end, a breaking force applied to each tab and each tab causes it to break from disposable part, respectively. To enable each tab to break cleanly from disposable parts and, a break or score line can be formed at the boundary of each tab and each disposable part to weaken the mechanical connection therebetween. A suitable breaking force can be applied to each tab by a mechanical press having a ram with a suitably shaped tip for causing the breaking force to be applied to the tab, especially the score line.

At a suitable time one or more electrical components, such as a packaged integrated circuit, an unpackaged flip-chip integrated circuit, a resistor, a capacitor and/or an inductor can be coupled to appropriate points of circuit pattern and/or circuit pattern of multi-layer PCB assembly in a manner known in the art. Moreover, one or more tabs can be coupled to a mounting fixture or an electrical fixture, such as a power supply. Since each tab is part of an electrically conductive sheet associated with first PCB layer, and since each tab is part of an electrically conductive sheet associated with second PCB layer, connecting one or more tabs to one terminal of power supply and connecting one or more tabs to the other terminal of power supply biases electrically conductive sheets accordingly. The provisioning of electrical power to electrically conductive sheets in this manner simplifies the provisioning of electrical power to each electrical component, e.g., electrical component, coupled to one or both outward facing surfaces of multi-layer PCB assembly .

In addition, other electrical components, such as one or more capacitors, can be connected between adjacent pairs of tabs. The inclusion of one or more capacitors between adjacent pairs of tabs reduces the need to install filter capacitors on one or both of the outward facing surfaces of multi-layer PCB assembly to provide electrical filtering for electrical components disposed thereon.

Like the distal end of exemplary tab, the distal end of each tab and the distal end of each tab includes an exposed edge of electrically conductive sheet , respectively. In addition, all or part of the top surface and/or bottom surface of the electrically conductive sheets associated with adjacent pairs of tabs and , respectively, can be exposed in order to facilitate the connection of electronic components, such as capacitors , therebetween.

As can be seen, the present invention provides a printed circuit board having one or more printed circuit board layers each of which has a conductive plane that extends to the edge of the printed circuit board but which is substantially, but not completely, covered by an insulating material. The edge of the conductive layer not covered by the insulating material is positioned on the edge of a tab which is utilized to couple the board to a disposable part of a larger panel that the printed circuit board is formed from during fabrication. The exposed edge of the conductive layer becomes exposed upon breaking the tab and singulating the printed circuit board from the disposable part of the panel.

The conductive layer of each circuit board layer can serve the dual purpose of conducting heat away from electrical components disposed on one or both surfaces of the printed circuit board or printed circuit board layer and providing power or ground to the electrical components.

The present invention has been described with reference to the preferred embodiments. Obvious modifications and alterations will occur to others upon reading and understanding the preceding detailed description. For example, multi-layer PCB assembly was described as being formed by laminating together PCB layers. However, a multi-layer PCB assembly can be formed from three or more PCB layers laminated together and electrically connected in a desired manner. Moreover, an electrical component, e.g., capacitor, was described as being connected to tabs of adjacent PCB layers of multi-layer PCB assembly. However, an electrical component can be connected between tabs of adjacent or non-adjacent PCB layers of a multi-layer PCB assembly having three or more PCB layers. It is intended that the invention be construed as including all such modifications and alterations insofar as they come within the scope of the appended claims.

## Claims

1. A circuit board comprising:
a conductive sheet sandwiched between an insulating top layer and an insulating bottom layer, the top and bottom layers and the conductive sheet defining a circuit board layer having an edge that includes an edge of the conductive sheet; and an insulating edge layer covering substantially, but
not completely, all of the edge of the conductive sheet, wherein the insulating layers are conformally coated on the conductive sheet,
wherein the conductive sheet includes a tab that extends outward from between the top layer and the bottom layer; and at least a part of the edge of the tab is exposed,
**characterized in that**
the tab has a top surface and bottom surface; and
at least part of at least one of the top surface and the bottom surface of the tab is exposed.

2. The circuit board as set forth in claim 1, wherein the conductive sheet includes at least one via there through.

3. The circuit board as set forth in claim 1 or 2, wherein the insulating layers are formed from a common dielectric material deposited on the conductive sheet.

4. The circuit board as set forth in any of claims 1 to 3, wherein at least one of the top and bottom layers has a circuit pattern formed thereon.

5. The circuit board as set forth in claim 1, wherein the tab terminates within the recess.

6. A circuit board according to claim 1, wherein
the tab extends into a recess in the circuit board layer.

7. The circuit board as set forth in claim 6, wherein the at least part of the edge is outside a perimeter of the circuit board layer.

8. The circuit board as set forth in any of claims 1 to 7, wherein a plurality of circuit board layers is laminated together to form a multi-layer circuit board.

9. The circuit board as set forth in claim 8, wherein the tab of one circuit board layer of the multi-layer circuit board is offset from the tab of another circuit board layer of the multi-layer circuit board.

10. The circuit board as set forth in claim 9, further including an electronic component connected between the tab of the one circuit board layer and the tab of the other circuit board layer.

11. The circuit board as set forth in any of claim 8 to 10, wherein:
the conductive sheet of the circuit board layer defines a power plane; and
the conductive sheet of another circuit board layer defines a ground plane.

12. The circuit board as set forth in any of claims 5 to 11, wherein:
the conductive sheet also comprises a panel; the tab joins the circuit board layer to the panel; and the tab is responsive to a breaking force for breaking where it joins the panel whereupon the circuit board layer and the tab separate from the panel.

13. A method of forming a circuit board comprising the steps of:
(a) providing a first conductive sheet;
(b) selectively removing one or more portions of the first conductive sheet to form a first panel having a first circuit board that is coupled to a disposable part of the first panel by at least one tab that extends from an edge of the first circuit board to an edge of the disposable part of the first panel;
(c) applying an insulating coating to the first circuit board so that at least each edge of the first circuit board is covered thereby, wherein the insulating coating is conformally coated on the conductive sheet and that at least part of at least one of the top surface and the bottom surface of the tab is not covered by the insulating coating; and
(d) separating the first circuit board from the disposable part in a manner whereupon at least part of the tab remains attached to the first circuit board and includes an exposed edge of the conductive sheet of the first circuit board.

14. The method as set forth in claim 13, wherein step (c) further includes applying the insulating coating to the first circuit board so that at least each edge of at least one tab is covered thereby.

15. The method as set forth in claim 13 or 14, wherein the at least part of the tab terminates one of inside and outside a perimeter of the first circuit board.

16. The method as set forth in any of claims 13 to 14, further including the steps of:
(e) providing a second conductive sheet;
(f) selectively removing one or more portions of the second conductive sheet to form a second panel having a second circuit board that is coupled to a disposable part of the second panel by at least one tab that extends from an edge of the second circuit board to an edge of the disposable part of the second panel;
(g) applying an insulating coating to the second circuit board so that at least each edge of the second circuit board is covered thereby;
(h) laminating the first and second circuit boards together; and
(i) separating the second circuit board from the disposable part of the second panel in a manner whereupon at least part of the tab remains attached to the second circuit board and includes an exposed edge of the conductive sheet of the second circuit board.

17. The method as set forth in claim 16, wherein the at least part of each tab terminates inside a perimeter of the corresponding circuit board.

18. The method as set forth in claim 16, wherein the at least part of each tab terminates outside a perimeter of the corresponding circuit board.

19. The method as set forth in claim 17 or 18, wherein the at least one tab of the first circuit board is offset from the at least one tab of the second circuit board.

20. The method as set forth in any of claims 17 to 19, further including the step of electrically connecting an electrical component between the at least one tab of the first circuit board and the at least one tab of the second circuit board.

## Patentansprüche

1. Leiterplatte umfassend:
eine leitende Platte geschichtet zwischen einer isolierenden oberen Schicht und einer isolierenden unteren Schicht, wobei die obere und die untere Schicht und die leitende Platte eine Leiterplattenschicht mit einem Rand bilden, der einen Rand von der leitenden Platte umfasst; und eine isolierende Randschicht, im Wesentlichen bedeckend, aber nicht vollständig, den gesamten Rand von der leitenden Platte, wobei die leitenden Schichten konform auf die leitende Platte geschichtet sind, wobei die leitende Platte einen Vorsprung umfasst, welcher sich zwischen der oberen Schicht und der unteren Schicht nach außen erstreckt; und wobei wenigstens ein Teil von dem Rand des Vorsprungs freiliegend ist,
**dadurch gekennzeichnet, dass**
der Vorsprung eine obere Oberfläche und eine untere Oberfläche hat; und wenigstens ein Teil von wenigstens einer der oberen Oberfläche und der unteren Oberfläche von dem Vorsprung freiliegend ist.

2. Leiterplatte wie in Anspruch 1 beansprucht, wobei die leitende Platte wenigstens ein Durchgangsloch hindurch umfasst.

3. Leiterplatte wie in Anspruch 1 oder 2 beansprucht, wobei die isolierenden Schichten aus einem üblichen dielektrischen Material geschichtet auf die leitende Platte gebildet sind.

4. Leiterplatte wie in einem der Ansprüche 1 bis 3 beansprucht, wobei wenigstens eine von der oberen und unteren Schicht einen Schaltkreis darauf gebildet hat.

5. Leiterplatte wie in Anspruch 1 beansprucht, wobei der Vorsprung innerhalb einer Einbuchtung endet.

6. Leiterplatte nach Anspruch 1, wobei der Vorsprung sich in eine Einbuchtung in der Leiterplattenschicht erstreckt.

7. Leiterplatte wie in Anspruch 6 beansprucht, wobei der wenigstens eine Teil des Randes außerhalb des Umfangs der Leiterplattenschicht ist.

8. Leiterplatte wie in einem der Ansprüche 1 bis 7 beansprucht, wobei eine Mehrzahl von Leiterplattenschichten zusammengeschichtet sind, um eine Multischicht-Leiterplatte zu bilden.

9. Leiterplatte wie in Anspruch 8 beansprucht, wobei der Vorsprung von einer Leiterplattenschicht von der Multischicht-Leiterplatte versetzt ist zu dem Vorsprung von einer anderen Leiterplattenschicht der Multischicht-Leiterplatte.

10. Leiterplatte wie in Anspruch 9 beansprucht, weiterhin umfassend eine elektronische Komponente, angeschlossen zwischen dem Vorsprung von der einen Leiterplattenschicht und dem Vorsprung von der anderen Leiterplattenschicht.

11. Leiterplatte wie in einem der Ansprüche 8 bis 10 beansprucht, wobei:
die leitende Platte von der Leiterplattenschicht eine Leiterebene bildet; und
die leitende Platte von einer anderen Leiterplattenschicht eine Masseebene bildet.

12. Leiterplatte wie in einem der Ansprüche 5 bis 11 beansprucht, wobei:
die leitende Platte ein Rahmenelement umfasst, wobei der Vorsprung der Leiterplattenschicht mit dem Rahmenelement verbunden ist; und der Vorsprung ansprechbar ist auf eine Brechkraft zum Brechen, wo er mit dem Rahmenelement verbunden ist, wodurch die Leiterplattenschicht und der Vorsprung von dem Rahmenelement getrennt werden.

13. Verfahren zum Herstellen einer Leiterplatte, umfassend die Schritte des:
(a) Bereitstellen einer ersten leitenden Platte;
(b) selektives Entfernen von einem oder mehreren Teilen von der ersten leitenden Platte, um ein erstes Rahmenelement mit einer ersten Leiterplatte, die mit dem wegwerfbaren Teil von dem ersten Rahmenelement durch wenigstens einen Vorsprung, der sich von einem Rand von der ersten Leiterplatte zu einem Rand von dem wegwerfbaren Teil von dem ersten Rahmenelement erstreckt, zu bilden;
(c) Aufbringen einer isolierenden Schicht auf die erste Leiterplatte, so dass wenigstens jeder Rand von der ersten Leiterplatte dadurch bedeckt ist, wobei die isolierende Beschichtung gleichmäßig auf die leitende Platte geschichtet ist und dadurch, dass wenigstens ein Teil von wenigstens einem von der oberen Oberfläche und der unteren Oberfläche von dem Vorsprung nicht durch die isolierende Beschichtung bedeckt ist; und
(d) Trennen von der ersten Leiterplatte von dem wegwerfbaren Teil in einer Art und Weise, in welcher wenigstens ein Teil von dem Vorsprung mit der ersten Leiterplatte verbunden bleibt und einen freiliegenden Rand von der leitenden Platte von der ersten Leiterplatte umfasst.

14. Verfahren wie in Anspruch 13 beansprucht, wobei Schritt (c) weiterhin das Aufbringen einer isolierenden Beschichtung auf die erste Leiterplatte umfasst, so dass wenigstens jeder Rand von wenigstens einem Vorsprung dadurch bedeckt ist.

15. Verfahren wie in Anspruch 13 oder 14 beansprucht, wobei der wenigstens eine Teil von dem Vorsprung entweder innerhalb oder außerhalb eines Umfangs von der ersten Leiterplatte endet.

16. Verfahren wie in einem der Ansprüche 13 bis 14 beansprucht, weiterhin umfassend die Schritte des:
(e) Bereitstellen einer zweiten leitenden Platte;
(f) selektives Entfernen von einem oder mehreren Teilen von der zweiten leitenden Platte, um ein zweites Rahmenelement mit einer zweiten leitenden Platte, die mit einem wegwerfbaren Teil von dem zweiten Rahmenelement durch wenigstens einen Vorsprung, der sich von einem Rand von der zweiten leitenden Platte zu einem Rand von dem wegwerfbaren Teil von dem zweiten Rahmenelement erstreckt, zu bilden;
(g) Aufbringen einer isolierenden Beschichtung auf die zweite leitende Platte, so dass wenigstens jeder Rand von der zweiten Leiterplatte dadurch bedeckt ist;
(h) Zusammenkleben der ersten und der zweiten Leiterplatte; und
(i) Trennen der zweiten Leiterplatte von dem wegwerfbaren Teil von dem zweiten Rahmenelement in einer Art und Weise, in welcher wenigstens ein Teil von dem Vorsprung mit der zweiten Leiterplatte verbunden bleibt und einen freiliegenden Rand von der leitenden Platte von der zweiten Leiterplatte umfasst.

17. Verfahren wie in Anspruch 16 beansprucht, wobei der wenigstens eine Teil von jedem Vorsprung innerhalb eines Umfangs von der entsprechenden Leiterplatte endet.

18. Verfahren wie in Anspruch 16 beansprucht, wobei der wenigstens eine Teil von dem Vorsprung außerhalb eines Umfangs der entsprechenden Leiterplatte endet.

19. Verfahren wie in einem der Ansprüche 17 oder 18 beansprucht, wobei der wenigstens eine Vorsprung von der ersten Leiterplatte versetzt ist zu dem wenigstens einen Vorsprung von der zweiten Leiterplatte.

20. Verfahren wie in einem der Ansprüche 17 bis 19 beansprucht, weiterhin umfassend den Schritt des elektrischen Verbindens einer elektrischen Komponente zwischen dem wenigstens einen Vorsprung von der ersten Leiterplatte und dem wenigstens einen Vorsprung von der zweiten Leiterplatte.

## Revendications

1. Carte de circuit comprenant :
une feuille conductrice prise en sandwich entre une couche supérieure isolante et une couche inférieure isolante, les couches supérieure et inférieure et la feuille conductrice définissant une couche de carte de circuit ayant un bord comprenant un bord de la feuille conductrice ; et une couche de bord isolante couvrant sensiblement, mais pas entièrement, tout le bord de la feuille conductrice, où les couches isolantes sont conformément enduites sur la feuille conductrice,
dans lequel la feuille conductrice comprend une languette qui s'étend vers l'extérieur en partant d'entre la couche supérieure et la couche inférieure ; et au moins une partie du bord de la languette est exposée ;
**caractérisé en ce que**
la languette a une surface supérieure et une surface inférieure ; et
au moins une partie d'au moins l'une de la surface supérieure et de la surface inférieure de la languette est exposée.

2. Carte de circuit selon la revendication 1, dans laquelle la feuille conductrice comprend au moins un trou d'interconnexion le traversant.

3. Carte de circuit selon la revendication 1 ou 2, dans laquelle les couches isolantes sont formées d'un matériau diélectrique commun déposé sur la feuille conductrice.

4. Carte de circuit selon l'une quelconque des revendications 1 à 3, dans laquelle un motif de circuit est formé sur au moins une des couches supérieure et inférieure.

5. Carte de circuit selon la revendication 1, dans laquelle la languette se termine à l'intérieur d'un évidement.

6. Carte de circuit selon la revendication 1, dans laquelle la languette s'étend dans un évidement dans la couche de carte de circuit.

7. Carte de circuit selon la revendication 6, dans laquelle la au moins une partie du bord est extérieure à un périmètre de la couche de carte de circuit.

8. Carte de circuit selon l'une quelconque des revendications 1 à 7, dans laquelle une pluralité de couches de carte de circuit sont stratifiées ensemble pour former une carte de circuit multicouche.

9. Carte de circuit selon la revendication 8, dans laquelle la languette d'une couche de carte de circuit de la carte de circuit multicouche est décalée par rapport à la languette d'une autre couche de carte de circuit de la carte de circuit multicouche.

10. Carte de circuit selon la revendication 9, comprenant en outre un composant électronique connecté entre la languette de la une couche de carte de circuit et la languette de l'autre couche de carte de circuit.

11. Carte de circuit selon l'une quelconque des revendications 8 à 10, dans laquelle :
la feuille conductrice de la couche de carte de circuit définit un plan d'alimentation ; et
la feuille conductrice d'une autre couche de carte de circuit définit un plan de masse.

12. Carte de circuit selon l'une quelconque des revendications 5 à 11, dans laquelle :
la feuille conductrice comprend en outre un panneau ; la languette relie la couche de carte de circuit au panneau ; et la languette est réactive à une force de rupture pour se rompre à l'endroit où elle se relie au panneau, sur quoi la couche de carte de circuit et la languette se séparent du panneau.

13. Procédé de formation d'une carte de circuit comprenant les étapes consistant à :
(a) fournir une première feuille conductrice ;
(b) enlever sélectivement une ou plusieurs portions de la première feuille conductrice pour former un premier panneau ayant une première carte de circuit qui est couplée à une partie jetable du premier panneau par au moins une languette qui s'étend d'un bord de la première carte de circuit vers un bord de la partie jetable du premier panneau ;
(c) appliquer un revêtement isolant sur la première carte de circuit de sorte qu'au moins chaque bord de la première carte de circuit est couvert par ce dernier, où le revêtement isolant est conformément enduit sur la feuille conductrice et qu'au moins une partie d'au moins l'une de la surface supérieure et de la surface inférieure de la languette n'est pas couverte par le revêtement isolant ; et
(d) séparer la première carte de circuit de la partie jetable d'une façon selon laquelle au moins une partie de la languette reste attachée à la première carte de circuit et comprend un bord exposé de la feuille conductrice de la première carte de circuit.

14. Procédé selon la revendication 13, dans lequel l'étape (c) comprend en outre l'application de la couche isolante sur la première carte de circuit de sorte qu'au moins chaque bord d'au moins une languette est couvert par cette dernière.

15. Procédé selon la revendication 13 ou 14, dans lequel la au moins une partie de la languette se termine à l'un de l'intérieur et de l'extérieur d'un périmètre de la première carte de circuit.

16. Procédé selon l'une quelconque des revendications 13 à 14, comprenant en outre les étapes consistant à :
(e) fournir une seconde feuille conductrice ;
(f) enlever sélectivement une ou plusieurs portions de la seconde feuille conductrice pour former un second panneau ayant une seconde carte de circuit qui est couplée à une partie jetable du second panneau par au moins une languette qui s'étend d'un bord de la seconde carte de circuit vers un bord de la partie jetable du second panneau ;
(g) appliquer un revêtement isolant sur la seconde carte de circuit de sorte qu'au moins chaque bord de la seconde carte de circuit est couvert par ce dernier ;
(h) stratifier les première et seconde cartes de circuit ensemble ; et
(i) séparer la seconde carte de circuit de la partie jetable du second panneau d'une manière selon laquelle au moins une partie de la languette reste attachée à la seconde carte de circuit et comprend un bord exposé de la feuille conductrice de la seconde carte de circuit.

17. Procédé selon la revendication 16, dans lequel la au moins une partie de chaque languette se termine à l'intérieur d'un périmètre de la carte de circuit correspondante.

18. Procédé selon la revendication 16, dans lequel la au moins une partie de chaque languette se termine à l'extérieur d'un périmètre de la carte de circuit correspondante.

19. Procédé selon la revendication 17 ou 18, dans lequel la au moins une languette de la première carte de circuit est décalée par rapport à la au moins une languette de la seconde carte de circuit.

20. Procédé selon l'une quelconque des revendications 17 à 19, comprenant en outre l'étape consistant à connecter électriquement un composant électrique entre la au moins une languette de la première carte de circuit et la au moins une languette de la seconde carte de circuit.
